# EUROPEAN PATENT SPECIFICATION

(11) **EP 0 878 833 B1**
(45) Date of publication and mention of the grant of the patent: **23.06.2010**
(21) Application number: 98830235.2
(22) Date of filing: 20.04.1998
(51) Int. Cl.: H01L 21/285, H01L 21/60

(54) **Process for the selective formation of salicide on active areas of MOS devices**
Verfahren zur selektiven Herstellung von Salizid über aktiven Oberflächen von MOS-Vorrichtungen
Procédé de formation sélective de salicide sur les aires actives de dispositifs MOS

(30) Priority: 13.05.1997 EP 97830219
(43) Date of publication of application: 18.11.1998
(73) Proprietor: STMicroelectronics Srl, 20041 Agrate Brianza (MB) (IT)
(72) Inventor: Moroni, Maurizio, 20017 RHO (Milano) (IT); Clementi, Cesare, 21052 Busto Arsizio (Varese) (IT)
(74) Representative: Mittler, Enrico

(56) References cited:
- EP-A- 0 334 761
- EP-A- 0 607 820
- US-A- 5 439 839
- US-A- 5 521 411
- US-A- 5 589 423
- US-A- 5 605 854
- PATENT ABSTRACTS OF JAPAN vol. 097, no. 007, 31 July 1997 & JP 09 082949 A (DENSO CORP), 28 March 1997
- KAZUHIRO KOBUSHI; ET AL: "A HIGH INTEGRITY AND LOW RESISTANCE TI-POLYCIDE GATE USING A NITROGEN ION-IMPLANTED BUFFER LAYER" JAPANESE JOURNAL OF APPLIED PHYSICS, vol. 27, no. 11, 1 November 1988 (1988-11-01), pages 2158-2160, XP000068677 JAPAN SOCIETY OF APPLIED PHYSICS, TOKYO,JP

## Description

The present invention relates to a process for the selective formation of salicide on active areas of MOS devices.

In the field of semiconductor integrated circuits it is known the use of composite materials comprising silicon and a transition metal (Ti, Co and the like), called silicides, for forming layers having a relatively small resistivity.

In particular, silicides are formed on active areas of MOS transistors for reducing the resistance of the source and drain diffusions, when these extend significantly.

A known method for forming a silicide layer on the active areas of MOS transistors provides for forming the gate of the transistor, comprising a gate oxide layer and a polysilicon layer, introducing in the silicon a dopant for the formation of the source and drain diffusions of the transistors, and then the deposition, over the whole surface of the silicon, of a transition metal, in particular Ti and Co, and the performing of a thermal process during which the transition metal reacts with the silicon for creating the silicide.

Since the silicide layer which forms on the active area of the MOS transistor is automatically aligned with the gate, the process is called "self-aligned-salicidation", shortly "salicidation", and the layer thus obtained is correspondingly called "salicide".

A drawback in the formation of salicide is due to the consumption of part of the silicon at the interface during the reaction between silicon and the transition metal.

In addition to this, during the salicidation process part of the dopant in the underlying silicon is absorbed.

For normal MOS transistors these effects are not particularly harmful, thanks to the substantial depth of the source and drain diffusions and their high doping level.

However, in some applications such as those providing for forming, by means of the "Drain-Extension" (DE) technique, N- or P-channel MOS transistors for high voltage (HV), the source and drain diffusions of the MOS transistors comprise a first region, lightly doped and shallow, and a second region, more heavily doped and of greater thickness, connected to the first region. For the fabrication of such transistors, after the formation of the gate a relatively small dose of dopant is introduced in the silicon, respectively of N type for the N-channel transistors and of type P for the P-channel ones, so as to form said first lightly doped regions of the source and drain diffusions which are automatically aligned with the gate. Successively, a high dose of dopant, of N or P type, is selectively implanted by way of a mask covering the gate and extending over the first lightly doped regions.

In order to form salicide over the source and drain diffusions of the transistors, a transition metal is then deposited over the whole silicon surface, and there is performed a thermal process.

The salicide thus forms both over the more heavily doped and deeper regions of the source and drain diffusions, where as already mentioned it does not causes particular problems, and over the more lightly doped and shallower regions of the source and drain diffusions.

In such regions, due to their low doping level and their small thickness, the absorption of dopant by the salicide and the consumption of part of the silicon for the formation of salicide can cause problems, for example the short-circuit of the salicide with the substrate.

US 5589423 discloses a process for the fabrication of a non-silicided region in an integrated circuit including the fabrication of a silicide blocking layer (24, 46, 54, 92, 112). In one embodiment, a field transistor (80) is formed by depositing a silicide blocking layer (84) overlying a field gate electrode (70) and source and drain regions (76, 78). A carbonaceous mask (86) is formed on the silicide blocking layer (84) overlying the field transistor (80). A partial etching process is performed to remove a portion of the silicide blocking layer (84) exposed by the carbonaceous mask (86). Then, the carbonaceous mask (86) is removed and the etching process is continued to completely remove portions of the silicide blocking layer (84) not originally protected by the carbonaceous mask (86). The etching process forms a silicide blocking layer (92) overlying the field transistor (80) and sidewall (94) adjacent to an MOS gate electrode (68).

An object of the present invention is that of providing a process of formation of salicide over active areas of MOS transistors, particularly of the type formed by means of the "drain-Extension" technique, allowing to overcome the above-mentioned problems, in particular avoiding to deteriorate existing lightly doped regions of the source and drain diffusions.

According to the invention, there is provided a method for forming a MOS transistor, according to claims 1 and 3.

The salicide is formed depositing over the whole surface of the semiconductor wafer a layer of a transition metal, but protecting (masking) those regions of the wafer where the salicide is not to be formed, in particular the first sub-regions of the source and drain regions of the MOS transistors, in such a way as the transition metal is in contact with the silicon over said second sub-regions but not over the first sub-regions. Submitting the wafer to a thermal process, the layer of transition metal reacts to form the salicide only in the regions where it is deposited directly over the silicon (mono- or poly-crystalline), remaining unmodified in the other regions, from which it can be removed.

Advantageously, for depositing the transition metal over said second sub-regions the same mask is used as that used for the selective introduction of dopant for the formation of the second sub-regions.

These and other features and advantages of the present invention will be made apparent by the following detailed description of some embodiments thereof, illustrated as non-limiting examples in the annexed drawings, wherein:
Figures 1 to 6 show steps of a process for manufacturing a N-channel MOSFET and a process for manufacturing a P-channel MOSFET;
Figure 7 shows a step of alternative process;
Figure 8 shows a transistor with a gate comprising three different layers
Figure 9 shows a transistor with a gate comprising four different layers;
Figures 10 to 13 show steps of a process according to a first embodiment of the invention, applied to an N-channel MOSFET;
Figure 14 shows an alternative of the process of Figures 10 to 13;
Figure 15 shows the use of the process of Figures 10 to 13 for the formation of salicide only over the gate of an N-channel MOSFET having lightly doped source and drain regions;
Figures 16 to 18 show steps of a process according to a second embodiment of the present invention.

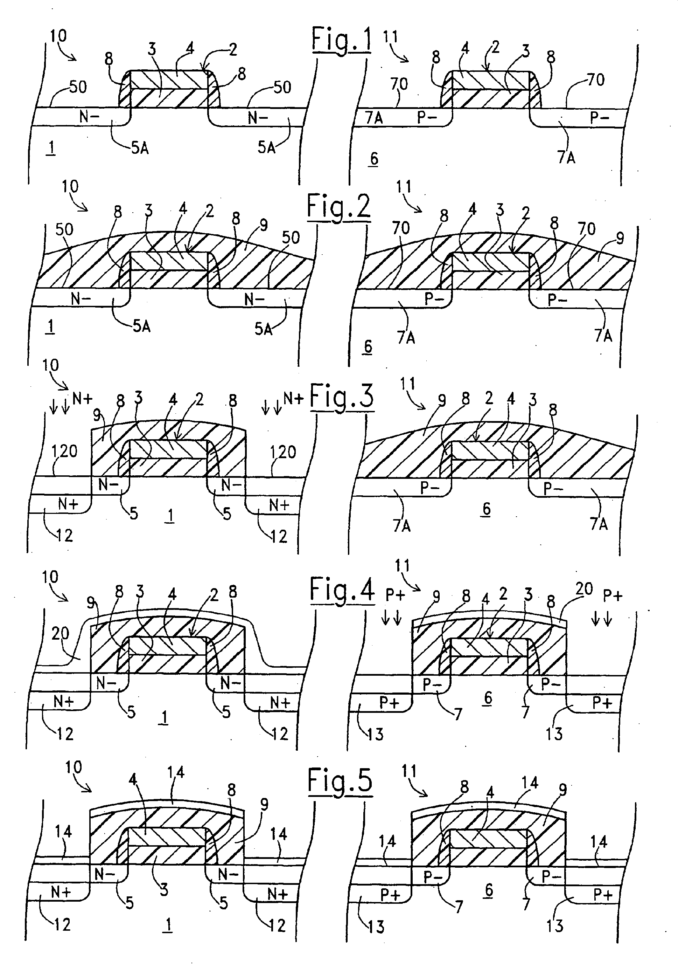

Figures 1-9, 14 and 15 and the text corresponding to all of these figures do not form part of the invention.

With reference to Figure 1, there are shown two MOS transistors 10, 11, respectively N-channel and P-channel, formed according to the known technique.

For the formation of the N-channel MOS transistor 10, over a P type substrate or well 1, particularly with dopant concentration of the order of 10²⁰ atoms/cm³, a gate 2 is formed comprising a gate oxide layer 3 and a polysilicon layer 4.

By the definition of the gate 2 there are defined two areas 50 for the formation of first lightly doped N- diffusions 5A of source and drain for MOS transistor 10, obtained by means of implantation and successive diffusion of N type ions in a dose of approximately 10¹² atoms/cm².

For the formation of P channel MOS transistor 11, over an N type substrate of well 6 there is formed (simultaneously with that of MOS transistor 10) a gate 2 comprising the gate oxide layer 3 and the polysilicon layer 4.

There are thus defined two areas 70 for the formation, by means of implantation of P type ions in a dose of approximately 10¹² atoms/cm² and their successive diffusion, of further first lightly doped P- source and drain diffusions 7A.

For both the devices 10 and 11 there are subsequently formed, by means of conventional techniques, dielectric material spacers 8 on both sides of the gate 2.

Over the whole surface of the silicon and over said devices 10, 11 (Fig. 2) there is then formed another layer of dielectric 9, particularly SiO₂, with thickness ranging from 200 to 500 Angstroms.

With reference to Figure 3, such a layer of dielectric 9, by means of a mask, is then etched away so as to uncover surface portions 120 of the first source and drain diffusions 5A of the N-channel MOS transistor 10. Inside said surface portions 120 there are formed implantations of N type ions at high dose, approximately of 10¹⁵ atoms/cm², so to form source and drain sub-regions 12 heavily doped N+.

In this way there are obtained source and drain regions 5, 12 for the N-channel transistor 10, each one formed by a first sub-region 5 lightly doped N- and a second sub-regions 12 more heavily doped N+.

After having performed a deposition of a layer of resist 20 to protect the sub-regions 12 from successive implants, as shown in Figure 4, there is performed a second masking and a successive etching for uncovering surface portions 130 of the first diffusions of source and drain, where there are performed implantations of P type ions at high doping level, approximately 10¹⁵ atoms/cm², for forming sub-regions 13 of source and drain heavily doped P+.

In this way there are obtained source and drain regions 7, 13 for the P-channel transistor 11, each one composed of a first sub-region 7 lightly doped P- and a second sub-region 13 more heavily doped P+.

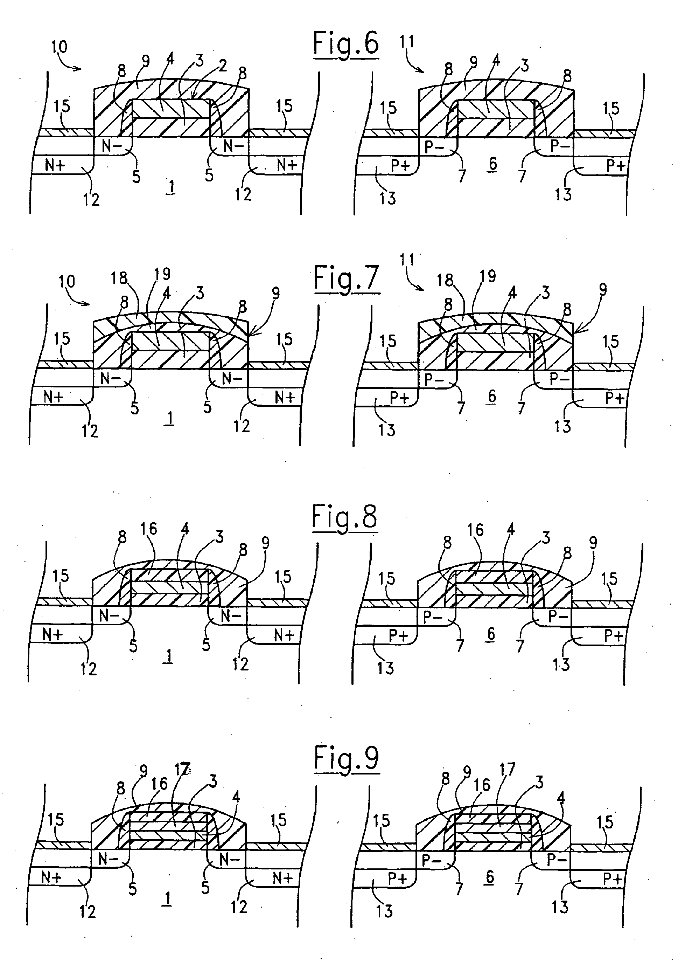

After having removed the resist layer 20, over the whole surface a layer of a transition metal 14 is deposited, for example Ti and Co (Figure 5), and a thermal process is then executed for the formation of a salicide layer 15. The salicide forms only where the transition metal is in contact with the silicon; over the dielectric 9 no salicide is formed; the transition metal is then removed (Figure 6). As appears from Figure 6, the presence of the dielectric 9, formed to mask the lightly doped source and drain sub-regions 5 and 7 and the gate 2 of the transistors from the implantations of ions at high dose, is advantageously used to protect regions 5, 7 and the gate 2 from salicidation, thus realizing this process only in the heavily doped sub-regions 12, 13.

As, shown in Figure 7, the dielectric layer 9 can comprise a double layer, a first one of SiO2 18, a second one of Si3N4 19, thus avoiding the direct contact between the silicon and the nitride of said second layer 19. Also in this case the overall thickness of layer 9 ranges from 200 to 500 Angstroms.

The process can also be applied to the salicidation of MOS transistors which, as shown in Figure 8, has a gate 2 comprising, in addition to the gate oxide layer 3 and the polysilicon layer 4, a further dielectric layer 16 suitable for example for improving the lithographic definition process of the gate, so as to avoid the contact between the polysilicon layer 4 and the overlying dielectric layer 9 used for the selective implantation of the high doses of N and P type dopants.

Similarly, the process can be applied to the salicidation of MOS transistor in which the gate 2, as shown in Figure 9, in addition to the gate oxide layer 3 and the polysilicon layer 4, also comprises a silicide layer 17 formed over the polysilicon layer 4. In this latter case, since salicidation 15 cannot be performed over the silicide layer 17, the gate 2 must comprise a further dielectric layer 16 covering the silicide layer 17 where the latter is not protected by the dielectric 9.

The gate 2 is thus defined leaving on the polysilicon 4 and silicide 17 the layer of residual dielectric 16. Once the spacers 8 have been formed, the process is performed.

There is thus obtained a process for the selective formation of salicide wherein the salicide layer is formed only over the heavily doped N+ and P+ sub-regions of source and drain 12, 13, and not over the more lightly doped N- or P- sub-regions 5 and 7; the first ones, due to their greater thickness and their higher doping level, are much less affected than the second one by deterioration caused by consumption of silicon during the salicidation and absorption of dopant by the salicide. Furthermore the process described does not require additional masks, because the mask already provided for the selective implantation of the high doses of N and P type dopants are exploited.

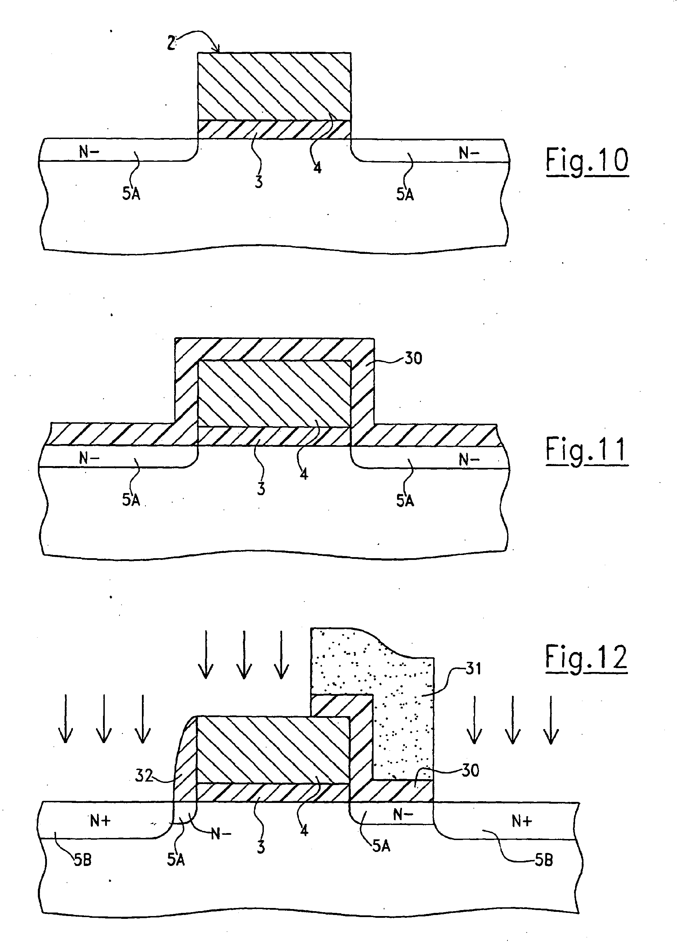

Referring now to Figures 10 to 13, there are shown some steps of a process according to a first embodiment of the present invention, referred for simplicity to the fabrication of an N-channel MOSFET only. The extension to a P-channel MOSFET is straightforward for the skilled technician

After having defined the insulated gate electrode of the MOSFET, comprising the gate oxide 3 and the polysilicon gate 4, and after having formed lightly doped N- source and drain regions by means of a Lightly Doped Drain (LDD) implant (N- for the N-channel MOSFETs, P- for the P-channel MOSFETs, with a dopant dose of approximately 10¹² and, respectively, 10¹³ atoms/cm²), the structure shown in Figure 10 is obtained.

A CVD (Chemical Vapor Deposited) dielectric layer 30 is then deposited over the surface. The dielectric layer 30 can be for example an oxide layer formed by TEOS or a layer of nitride, and has preferably a thickness of 150 to 300 nanometers.

A photoresist mask layer 31 is then formed over the structure. A selective etching of the dielectric layer 30 is then performed; where the mask layer 31 is present, the dielectric layer 30 is not removed. As visible from Figure 12, the mask layer 31 leaves a portion of the N- drain region 5A of the MOSFET covered; at the source side, instead, where the mask layer is not present, during the etching process an insulating sidewall spacer 32 is formed.

By means of the same mask layer 31, a selective implantation of a high dose of dopants (e.g., 1015 atoms/cm²) is then performed, so as to form heavily doped N+ source and drain portions 5B. It is to be noted that this selective implant step could as well be performed using a different mask, formed over the structure after the removal of the photoresist layer 31.

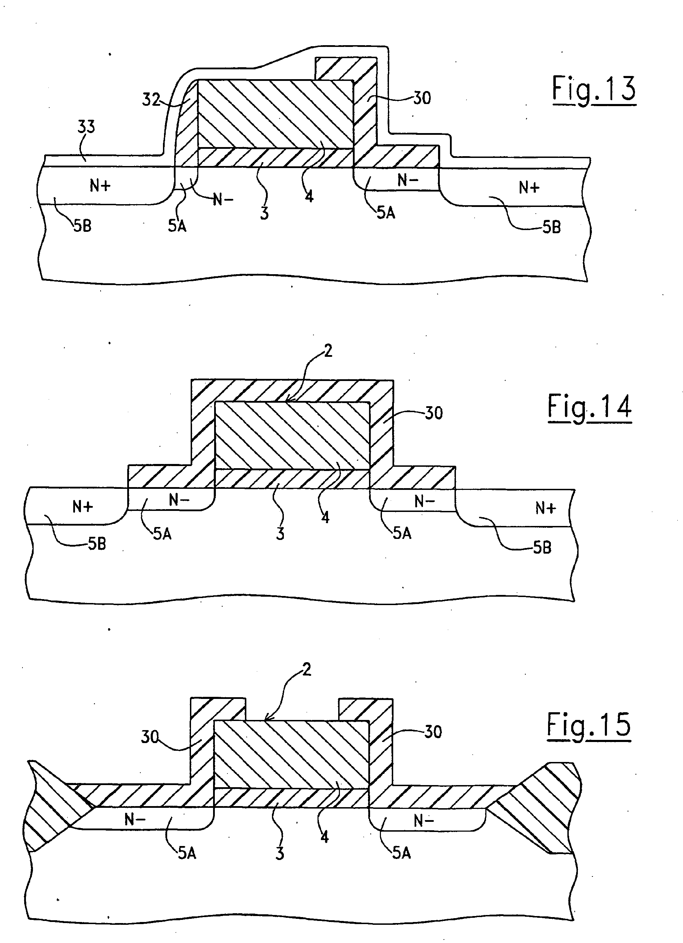

Then, as shown in Figure 13, a layer of a transition metal 33 is deposited over the whole surface. A thermal process is then performed so as to form, where the transition metal layer is in direct contact with silicon or with polysilicon, a salicide layer, as previously described.

It is to be noted that, thanks to this first embodiment of the invention, the dimension of the N- region 5A at the drain side can be varied as desired.

In Figure 14, the dielectric layer 30 is left over the whole polysilicon gate 4 of the MOSFET, and also covers a portion of the N- source region 5A. Thus, the salicide layer will only be formed over the heavily doped portions 5B of the source and drain regions of the MOSFET.

Evidently, the polysilicon gate 4 of the MOSFETs can comprise a layer of polycide, such as for example WSi2.

The process of Figures 10 to 13 also allows for preventing the formation of salicide over the source and drain regions of MOSFETs that do not comprise heavily doped source and drain region portions, as shown in Figure 15. The dielectric layer 30 can cover completely the polysilicon gate 4 or, as shown in Figure 15, the polysilicon gate 4 can be left exposed so that a salicide layer is formed over the polysilicon gate 4.

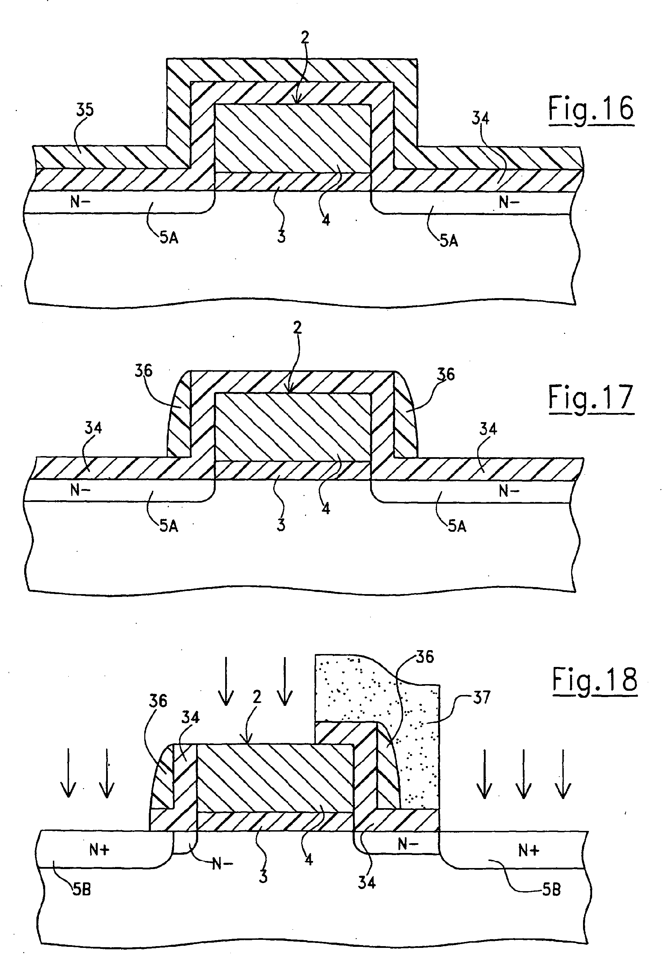

A second embodiment of the invention is shown in Figures 16 to 18. In this embodiment, starting from the structure shown in Figure 10, two dielectric films 34, 35 are deposited sequentially; the two films preferably have different etch rates.

Then, without using any mask, the upper film 35 is etched. The etching process is stopped when the surface of the lower dielectric film 34 is reached; this can be advantageously achieved if the two films 34, 35 have different etch rates. In this way, as shown in Figure 17, dielectric sidewall spacers 36 are formed.

Then a photoresist mask layer 37 is formed over a portion of the N-drain region of the MOSFET, and the lower dielectric film 34 is etched down to the silicon surface where the dielectric film 34 is not covered by either the mask layer 37 or the spacer 36.

Then, a high dose of dopants (N type in the case of an N-channel MOSFET, P type in the case of a P-channel one) is implanted as in Figure 12, so as to obtain the structure shown in Figure 18.

It should also be noted that the upper film 35 not necessarily is a dielectric film: it could as well be a conductive, which can be selectively removed after the etching processes, before or after the implant steps.

Even if the invention has been described in connection with normal N-channel and P-channel MOS transistors, it is apparent that the invention can be straightforwardly applied also in the case said MOS transistors are of the "stacked gate" type used for example to form non-volatile memory cells.

## Claims

1. Method for forming a MOS transistor comprising the successive steps of:
- providing a gate (2) having a layer of gate oxide (3) and a polysilicon layer (4) overlaying said gate oxide layer (3);
- implanting and subsequent diffusing lightly doped source and drain regions (5A) on either side of said gate;
- depositing a dielectric layer (30) over all the transistor;
- forming a photoresist mask layer (31) over all the transistor;
- etching selectively said dielectric layer (30) leaving a portion of said lightly doped drain region and a portion of said gate covered where the mask layer is present and forming a sidewall spacer (32) at source region side where the mask layer is not present;
- implanting dopants at high dose to form heavily doped source and drain regions on portions not covered by said photoresist mask layer (31) or said sidewall spacer (32);
- depositing a layer of a transition metal (33) on all the transistor;
- executing a thermal process for the formation of a salicide layer;
- removing the transition metal (33) over said transistor.

2. Method according to claim 1, **characterized in that** said dielectric layer (30) has a thickness of 150 to 300 nanometers.

3. Method for forming a MOS transistor comprising the successive steps of:
- providing a gate (2) having a layer of gate oxide (3) and a polysilicon layer (4) overlaying said gate oxide layer (3);
- implanting and subsequent diffusing lightly doped source and drain regions (5A) on either side of said gate;
- depositing a first dielectric layer (34) over all the transistor;
- depositing a second dielectric layer (35) over all the transistor, said first dielectric layer (34) and said second dielectric layer (35) having different etch rates;
- etching said second dielectric layer (35) until the surface of the first dielectric layer (34) is reached and forming a couple of sidewall spacers (36) at source region and at drain region sides;
- forming a photoresist mask layer (37) over a portion of said lightly doped drain region;
- etching selectively said first dielectric layer (34) where the first dielectric layer is not covered by either the mask layer (37) or the spacer (36);
- implanting dopants at high dose to form heavily doped source and drain regions on portions not covered by said first dielectric layer (34) or said sidewall spacer (36);
- depositing a layer of a transition metal (33) on all the transistor;
- executing a thermal process for the formation of a salicide layer;
- removing the transition metal (33) over said transistor.

4. Method according to claim 1 or 3, **characterized in that** said high dose of dopants is 10¹⁵ atoms/cm².

5. Method according to claim 1 or 3, **characterized in that** said low dose of dopants is 10¹² atoms/cm² for a n-channel MOSFET.

## Patentansprüche

1. Verfahren zum Herstellen eines MOS-Transistors, wobei das Verfahren der Reihe nach folgende Schritte aufweist:
- Bereitstellen eines Gates (2), das eine Gateoxidschicht (3) und eine über der Gateoxidschicht (3) angeordnete Polysiliziumschicht (4) aufweist;
- Implantieren und anschließende Eindiffundieren von schwach dotierten Source- und Drainbereichen (5A) beidseits von dem Gate;
- Aufbringen einer dielektrischen Schicht (30) über dem gesamten Transistor;
- Bilden einer Fotoresist-Maskierschicht (31) über dem gesamten Transistor;
- selektives Ätzen der dielektrischen Schicht (30), wobei ein Teil des schwach dotierten Drainbereichs und ein Teil des Gates dort bedeckt verbleiben, wo die Maskierschicht vorhanden ist, und Bilden eines Seitenwand-Abstandselements (32) auf der Sourcebereichseite, auf der die Maskierschicht nicht vorhanden ist;
- Implantieren von Dotierstoffen in hoher Dosis zum Bilden von stark dotierten Source- und Drainbereichen in Regionen, die nicht von der Fotoresist-Maskierschicht (31) oder dem Seitenwand-Abstandselement (32) bedeckt sind;
- Aufbringen einer Schicht aus einem Übergangsmetall (33) auf dem gesamten Transistor;
- Ausführen eines thermischen Verfahrens zum Bilden einer Salizidschicht;
- Entfernen des Übergangsmetalls (33) über dem Transistor.

2. Verfahren nach Anspruch 1,
**dadurch gekennzeichnet, dass** die dielektrische Schicht (30) eine Dicke von 150 bis 300 Nanometern aufweist.

3. Verfahren zum Herstellen eines MOS-Transistors, wobei das Verfahren der Reihe nach folgende Schritte aufweist:
- Bereitstellen eines Gates (2), das eine Gateoxidschicht (3) und eine über der Gateoxidschicht (3) angeordnete Polysiliziumschicht (4) aufweist;
- Implantieren und anschließendes Eindiffundieren von schwach dotierten Source- und Drainbereichen (5A) beidseits von dem Gate;
- Aufbringen einer ersten dielektrischen Schicht (34) über dem gesamten Transistor;
- Aufbringen einer zweiten dielektrischen Schicht (35) über dem gesamten Transistor, wobei die erste dielektrische Schicht (34) und die zweite dielektrische Schicht (35) unterschiedliche Ätzraten aufweisen;
- Ätzen der zweiten dielektrischen Schicht (35) bis zum Erreichen der Oberfläche der ersten dielektrischen Schicht (34) und Bilden eines Paares von Seitenwand-Abstandselementen (36) auf der Sourcebereichseite und der Drainbereichseite;
- Bilden einer Fotoresist-Maskierschicht (37) über einem Teil des schwach dotierten Drainbereichs;
- selektives Ätzen der ersten dielektrischen Schicht (34) in dem Bereich, in dem die erste dielektrische Schicht nicht von der Maskierschicht (37) oder von dem Abstandselement (36) bedeckt ist;
- Implantieren von Dotierstoffen in hoher Dosis zum Bilden von stark dotierten Source- und Drainbereichen in Regionen, die nicht von der ersten dielektrischen Schicht (34) oder von dem Seitenwand-Abstandselement (36) bedeckt sind;
- Aufbringen einer Schicht aus einem Übergangsmetall (33) auf dem gesamten Transistor;
- Ausführen eines thermischen Verfahrens zum Bilden einer Salizidschicht;
- Entfernen des Übergangsmetalls (33) über dem Transistor.

4. Verfahren nach Anspruch 1 oder 3,
**dadurch gekennzeichnet, dass** die hohe Dosis der Dotierstoffe 10¹⁵ Atome/cm² beträgt.

5. Verfahren nach Anspruch 1 oder 3,
**dadurch gekennzeichnet, dass** die niedrige Dosis der Dotierstoffe 10¹² Atome/cm² für einen n-Kanal-MOSFET beträgt.

## Revendications

1. Procédé pour former un transistor MOS comprenant les étapes successives consistant à :
placer une grille (2) ayant une couche d'oxyde de grille (3) et une couche de polysilicium (4) recouvrant ladite couche d'oxyde de grille (3) ;
implanter et diffuser ensuite des régions de source et de drain (5A) légèrement dopées sur les deux côtés de ladite grille ;
déposer une couche diélectrique (30) sur tout le transistor ;
former une couche de masque photorésistante (31) sur tout le transistor ;
graver sélectivement ladite couche diélectrique (30) en laissant une partie de ladite région de drain légèrement dopée et une partie de ladite grille couvertes là ou la couche de masque est présente et former une paroi latérale d'espacement (32) au niveau du côté de la région de source où la couche de masque n'est pas présente ;
implanter des dopants à haute dose pour former des régions de source et de drain fortement dopées sur des parties non couvertes par ladite couche de masque photorésistante (31) ou ladite paroi latérale d'espacement (32) ;
déposer une couche d'un métal de transition (33) sur tout le transistor ;
exécuter un processus thermique pour la formation d'une couche de saliciure ;
enlever le métal de transition (33) sur ledit transistor.

2. Procédé selon la revendication 1, **caractérisé en ce que** ladite couche diélectrique (30) a une épaisseur de 150 à 300 nanomètres.

3. Procédé pour former un transistor MOS comprenant les étapes successives consistant à :
placer une grille (2) ayant une couche d'oxyde de grille (3) et une couche de polysilicium (4) recouvrant ladite couche d'oxyde de grille (3) ;
implanter et diffuser ensuite des régions de source et de drain (5A) légèrement dopées sur les deux côtés de ladite grille ;
déposer une première couche diélectrique (34) sur tout le transistor ;
déposer une seconde couche diélectrique (35) sur tout le transistor, ladite première couche diélectrique (34) et ladite seconde couche diélectrique (35) ayant des taux de gravure différents ;
graver ladite seconde couche diélectrique (35) jusqu'à ce que la surface de la première couche diélectrique (34) soit atteinte et former un couple de parois latérales de séparation (36) au niveau des côtés de région de source et de région de drain ;
former une couche de masque photorésistante (37) une partie de ladite région de drain légèrement dopée ;
graver sélectivement ladite première couche diélectrique (34) là où la première couche diélectrique n'est pas couverte par soit la couche de masque (37) ou la séparation (36) ;
implanter des dopants à haute dose pour former des régions de source et de drain fortement dopées sur des parties non couvertes par ladite première couche diélectrique (34) ou ladite paroi latérale d'espacement (36) ;
déposer une couche d'un métal de transition (33) sur tout le transistor ;
exécuter un processus thermique pour la formation d'une couche de saliciure ;
enlever le métal de transition (33) sur ledit transistor.

4. Procédé selon la revendication 1 ou 3, **caractérisé en ce que** ladite haute dose de dopants est de 10¹⁵ atomes/cm².

5. Procédé selon la revendication 1 ou 3, **caractérisé en ce que** ladite faible dose de dopants est de 10¹² atomes/cm² pour un canal MOSFET.
